# EUROPÄISCHE PATENTSCHRIFT

(11) **EP 0 973 206 B1**
(45) Veröffentlichungstag und Bekanntmachung des Hinweises auf die Patenterteilung: **26.05.2004**
(21) Anmeldenummer: 99112318.3
(22) Anmeldetag: 26.06.1999
(51) Int. Cl.: H01L 29/78, H01L 21/336, H01L 21/8234, H01L 21/266, H01L 29/10

(54) **Hochspannungsfestigkeits-MIS-Transistor**
High withstand voltage MIS transistor
Transistor de type MIS à tension de tenue élevée

(30) Priorität: 26.06.1998 DE 19828521
(43) Veröffentlichungstag der Anmeldung: 19.01.2000
(73) Patentinhaber: ELMOS Semiconductor AG, 44227 Dortmund (DE)
(72) Erfinder: Giebel, Thomas, Dr., 44139Dortmund (DE)
(74) Vertreter: Hilleringmann, Jochen, Dipl.-Ing.

(56) Entgegenhaltungen:
- WO-A-97/13277
- US-A- 4 933 730
- US-A- 4 990 982
- TSAI C -Y ET AL: "OPTIMIZED 25V, 0.34MOMEGA.CM2 VERY-THIN-RESURF (VTR), DRAIN EXTENDED IGFETS IN A COMPRESSED BICMOS PROCESS" INTERNATIONAL ELECTRON DEVICES MEETING (IEDM),US,NEW YORK, IEEE, 8. Dezember 1996 (1996-12-08), Seiten 469-472, XP000753793 ISBN: 0-7803-3394-2
- PATENT ABSTRACTS OF JAPAN vol. 1995, no. 04, 31. Mai 1995 (1995-05-31) & JP 07 030107 A (SONY CORP), 31. Januar 1995 (1995-01-31)

## Beschreibung

Die Erfindung betrifft einen MOS-Transistor mit hoher Spannungsfestigkeit und geringem Einschaltwiderstand. Insbesondere betrifft die Erfindung einen PMOS-Transistor, der über eine hohe Spannungsfestigkeit bei geringem Einschaltwiderstand verfügt.

Aus US-A-4,933,730 ist ein MOS-Transistor mit hoher Verstärkung bekannt, der einen relativ kurzen (Enhancement-)Kanal aufweist, welcher durch selbstjustierende Implantation auf der sourceseitigen Gate-Kante sowie durch anschließende Diffusion erzeugt ist. In Richtung auf das Drain-Gebiet schließt sich an den kurzen Kanal ein relativ langer Depletion-Bereich an, der sich unterhalb der Gate-Elektrode erstreckt und zwei nebeneinander liegende, unterschiedlich schwach dotierte Gebiete aufweist, die durch zwei Ionenimplantationen erzeugt sind. Derartige Depletion-Bereiche führen zu einer verhältnismäßig geringen Spannungsfestigkeit. Ferner ist der bekannte MOS-Transistor mit einer einfach implantierten Driftzone versehen, deren Dotierstoffkonzentration über ihre Länge betrachtet im wesentlichen konstant ist.

Ein Hochvolt-PMOS-Transistor mit einer Durchbruchspannung von ca. 44 V ist in EP-A-91 911 911 (Veröffentlichungsnummer EP 0 536 227 B1) beschrieben. Gerade im Automotive-Bereich werden jedoch erhöhte Anforderungen an die Durchbruchspannungsfestigkeit gestellt. So ist es beispielsweise wünschenswert, wenn ein PMOS-Transistor eine Spannungsfestigkeit von > 60 V, vorzugsweise ca. 80 V aufweist, wobei zusätzlich gefordert wird, daß der Einschaltwiderstand dieses Transistors relativ gering ist.

Die Spannungsfestigkeit von MOS-Transistoren setzt voraus, daß das elektrische Feld zwischen der drainseitigen Gate-Kante und dem Drain abgebaut und die Stärke des elektrischen Feldes an der drainseitigen Gate-Kante verringert wird. Dies läßt sich prinzipiell dadurch erreichen, daß das Drain von der drainseitigen Gate-Kante beabstandet wird und zwischen dem Draingebiet und dem Gate ein sogenanntes Drainextension-Gebiet angeordnet wird., das eine geringere Konzentration an Ladungsträgern aufweist. Das Drainextension-Gebiet erstreckt sich dabei um das Draingebiet herum, so daß letzteres innerhalb des ersteren angeordnet wird.

Mit einem derartigen Drainextension-Gebiet läßt sich aufgrund der relativ niedrigen Konzentration an Ladungsträgern das elektrische Feld zwischen Drain und drainseitiger Gate-Kante ausreichend stark abbauen und die Stärke des elektrischen Feldes an der Gate-Kante in ausreichendem Maße verringern. Allerdings steigt bei einem derartigen Transistor-Design der Einschaltwiderstand an. Dieser Einschaltwiderstand kann abgesenkt werden, wenn es gelingt, die Ladungsträgerkonzentration im Drainextension-Gebiet ausgehend von der drainseitigen Gate-Kante bis zum Drain-Gebiet allmählich zu erhöhen. Ein Beispiel für einen derartigen MOS-Transistor mit lateral moduliertem Drainextension-Gebiet ist aus WO-A-97/13277 bekannt. Dort wird die Laterialmodulation der Dotierstoffkonzentration im Drainextension-Gebiet durch Einbringen einer n-Ionenimplantation unter Ausmaskierung mindestens eines Abstandsbereichs erzielt, wobei die nach der Ionenimplantation getrennten Implantationsgebiete durch anschließende thermisch induzierte Diffusion "ineinanderlaufen". In diesen Bereichen ist dann die Dotierstoffkonzentration verringert.

Steht allerdings für die Ausbildung des Drainextension-Gebiets lediglich eine Ionenimplantation ohne anschließende thermisch induzierte Diffusion zur Verfügung, so kann man gemäß den in der zuvor genannten PCT-Veröffentlichung angegebenen Maßnahmen nicht verfahren, um eine Lateralmodulation im ionenimplantierten Drainextension-Gebiet zu realisieren. Eine Alternative bestünde darin, das Drainextension-Gebiet durch Einbringen mehrerer Ionenimplantationen mit unterschiedlicher Energie aufzubauen. Dies allerdings erfordert zusätzliche Prozeßschritte, was insoweit nachteilig ist.

Der Erfindung liegt die Aufgabe zugrunde, einen MOS-Transistor mit hoher Spannungsfestigkeit und geringem Einschaltwiderstand zu schaffen, dessen Drainextension-Gebiet ionenimplantiert ist, wobei der Ionenimplantationsschritt zur Erzeugung des Drainextension-Gebiets unverändert bleiben soll.

Zur Lösung dieser Aufgabe wird mit der Erfindung ein MOS-Transistor mit hoher Spannungsfestigkeit und geringem Einschaltwiderstand gemäß Anspruch 1 vorgeschlagen.

Bei dem erfindungsgemäßen MOS-Transistor, der insbesondere in Form eines PMOS-Transistors realisiert ist, wird die zur Erzeugung des n-Wannengebiets erforderliche n-Ionenimplantation in einem Abstandsbereich ausmaskiert. Dieser Abstandsbereich liegt innerhalb des Drainextension-Gebiets und ist von der drainseitigen Gate-Kante beabstandet. Innerhalb dieses Abstandsbereichs befindet sich das spätere Drain-Gebiet oder es ragt zumindest teilweise in diesen Abstandsbereich hinein.

Durch die Ausmaskierung bei der n-Ionenimplantation werden zwei voneinander getrennte n-Ionenimplantationsgebiete im p-Substrat geschaffen, die bei der anschließenden thermisch induzierten Diffusion "ineinanderlaufen" und damit untereinander verbunden sind. In diesem Verbindungsbereich, der mit dem Abstandsbereich fluchtet, weist das n-Wannengebiet eine geringere Konzentration an n-Dotierung, beispielsweise Phosphor-Dotierung, auf. Wird in diesen derart präparierten Bereich des n-Wannengebiets eine p-Ionenimplantation eingebracht, wobei das Ionenimplantationsgebiet den Verbindungsbereich an den beiden einander gegenüberliegenden Seiten überragt, so weist dieses p-Ionenimplantationsgebiet innerhalb des Verbindungsbereiches wegen der dort geringeren n-Dotierstoffkonzentration eine erhöhte Konzentration an aktiven p-Dotierstoff auf. Demgegenüber ist die p-Dotierstoffkonzentration in den beidseitig des Verbindungsbereichs angrenzenden Gebieten geringer, da im n-Gebiet die Dotierstoffkonzentration höher ist. Auf diese Weise entsteht also ein lateral moduliertes Ionenimplantationsgebiet, das sich aufgrund seiner Dotierstoffkonzentrationsmodulation als Drainextension-Gebiet eignet, um die obigen Anforderungen zu erfüllen. Die Lage dieses Drainextension-Gebiets innerhalb des n-Wannengebiets ist dabei derart gewählt, daß sich ein erstes Teilgebiet des Drainextension-Gebiets, das außerhalb des Verbindungsbereichs liegt, bis unterhalb der drainseitigen Gate-Kante angeordnet ist, während innerhalb des zweiten Drainextension-Teilgebiets, in dem die P-Dotierstoffkonzentration erhöht ist, zumindest ein Teil, vorzugsweise das gesamte Draingebiet, angeordnet ist.

Damit hat man also letztendlich durch einen Ausmaskierungsschritt bei der Schaffung des n-Wannengebiets die Voraussetzungen dafür geschaffen, daß das Drainextension-Gebiet trotz seiner Ausbildung durch eine über das gesamte Gebiet gleiche unveränderte Ionenimplantation ein Lateral-Dotierstoffkonzentrationsprofil aufweist. Dieses Profil ist derart beschaffen, daß die Dotierstoffkonzentration im an die drainseitige Gate-Kante angrenzenden Bereich verringert und im Anschluß daran zum Draingebiet hin erhöht ist. Damit weist der so hergestellte MOS-Transistor einerseits eine vergleichsweise hohe Spannungsfestigkeit auf, da nämlich das elektrische Feld zur drainseitigen Gate-Kante hin abgebaut und die elektrische Feldstärke am Gate relativ gering ist während der Einschaltwiderstand aufgrund der erhöhten Dotierstoffkonzentration im an das Draingebiet angrenzenden Drainextension-Bereich erhöht ist.

Der erfindungsgemäße MOS-Transistor läßt sich also in einem herkömmlichen CMOS-Prozeß herstellen, wobei Spannungsfestigkeiten von > als 60 V U_{DS} bis zu 80 V U_{DS} bei geringem flächenbezogenen Einschaltwiderstand realisiert werden können.

Eine weitere wenn auch nicht übermäßig starke Erhöhung der Spannungsfestigkeit kann dadurch realisiert werden, daß in das Drainextension-Gebiet die Ionenimplantation zur Einstellung der Schwellenspannung des MOS-Transistors eingebracht wird. Hierbei ist jedoch zu beachten, daß diese Schwellenspannungsimplantation an der drainseitigen Gate-Kante ausmaskiert ist, um dort die Ladungsträgerkonzentration durch die zusätzliche Implantation nicht zu erhöhen. Die zusätzlich eingebrachte Schwellenspannungsimplantation erhöht zum einen die Spannungsfestigkeit und zum anderen verringert sie, wenn auch nur geringfügig, den flächenbezogenen Einschaltwiderstand.

Zusammenfassend kann also gesagt werden, daß das wesentliche Problem bekannter HV-Transistoren in der zu hohen Dotierung der Drainextension, insbesondere bei flacher Drainextension-Implantation (z. B. 180 kV, 3E12) im Zusammenhang mit dem hohen elektrischen Feld an der drainseitigen Gate-Kante zu sehen ist. Also müssen die Dotierung und das elektrische Feld in diesem Bereich verringert werden.

Eine neue Idee zu dieser Problematik ermöglicht die laterale Modellierung der Dotierstoffkonzentration in der Driftstrecke. Dadurch kann man die Dotierstoffkonzentration im Bereich des hohen elektrischen Feldes an der drainseitigen Gatekante niedrig und damit die Durchbruchspannung hoch halten, während die Dotierstoffkonzentration in der Driftstrecke zum Drain p+ Anschlußgebiet ansteigt und damit die Leitfähigkeit des Gebietes zunimmt.

Dazu wird die Wannen-Implantation im Bereich des Überganges vom p+Drain-Anschlußgebiet zur Driftstrecke ausmaskiert und damit die Phosphorkonzentration nach der Ausdiffusion der Wanne in diesem Bereich abgesenkt. Damit wird in diesem Bereich die elektrisch aktive Borkonzentration der Driftstrecke angehoben und damit die Leitfähigkeit erhöht. In lateraler Richtung zur Drainseitigen Gatekante steigt die Phosphorkonzentration durch die Ausdiffusion der Wannen-Implantation an und die elektrisch aktive Borkonzentration sinkt. Damit ist gesichert, daß im diesem kritischen Bereich der pn-Übergang recht weich ist und damit das elektrische Feld ausreichend klein bleibt.

Als Drainextension wird bei dem neuen PMOS die im LOCOS-Prozeß zweiteilige NMOS-Schwellen-Implantation benutzt. Normalerweise wird die tiefe, hochenergetische Implantation mit Bor zur Einstellung der Feldschwellenspannung im NMOS-Bereich, die niederenergetische Implantation zur Einstellung der Schwellenspannung der NMOS-Transistoren benutzt. Innnerhalb der n-Wanne wird durch diese Doppelimplantation innerhalb eines Aktivgebiets ein p-Gebiet geschaffen, welches durch Tiefe und Profil gut als Drainextension geeignet ist.

Diese Drainextension sollte das später erzeugte Gate zur Kanalanbindung um 1 µm überlappen. Das p+Drainanschlußgebiet muß sowohl von der drainseitigen Gatekante als auch von der Aktivgbietskante einen Abstand haben, da sonst an beiden Stellen kritische Feldstärkespitzen entstehen.
Soweit der klassische Ansatz unter vorteilhafter Ausnutzung von vorhandenen Prozeßschritten.

Die zur Einstellung der PMOS-Schwellenspannung benutzte sehr flache Bor-Implantation muß im Bereich der drainseitigen Gatekante ausmaskiert werden. Dadurch wird die Bor-Konzentration in diesem Bereich abgesenkt, die Raumladungszone kann sich in diesem Bereich weiter ausdehnen und das elektrische Feld wird damit abgeschwächt, was zur weiteren Erhöhung der Durchbruchspannung führt.

Um den On-Widerstand des Transistors im leitenden Zustand zu verringern, kann man entweder die Dotierstoffkonzentration der Drainextension erhöhen oder die Driftstrecke verkürzen. Beides führt aber zu niedrigeren Durchbruchspannungen, da die Feldstärke im Bereich der drainseitigen Gatekante hierdurch erhöht wird. Besser wäre es, wenn die elektrisch aktive Dotierstoffkonzentration und damit die Leitfähigkeit von der drainseitigen Gatekante zu dem p+ Draingebiet in lateraler Richtung ansteigen würde. Damit wird eine gute Potentialverteilung im kritischen Bereich und eine insgesamt niederohmigere Anbindung des p+Draingebiets erreicht. Dies kann aber normalerweise nur durch einen zusätzlichen Diffusionsschritt im Prozeß erreicht werden, was sich wegen der weitreichenden Konsequenzen für den Gesamtprozeß und alle anderen Bauelemente verbietet. Da aber in diesem Bereich die elektrisch aktive Dotierung von zwei Dotierstoffen, Bor und Phosphor, bestimmt wird eröffnet sich die Möglichkeit, die elektrisch aktive Borkonzentration durch Verringerung der Phosphorkonzentration zu erhöhen. Dazu wird die Wannen-Implantation im Bereich des p+ Draingebiets ausmaskiert. Durch die Nachdiffusion diffundieren die beiden Wannenteile wieder zusammen und man erreicht so eine verringerte Phosphorkonzentration in diesem Bereich. Damit steigt in der sich anschließenden Bor-Implantation die elektrisch aktive Dotierung und damit die Leitfähigkeit der Driftstrecke um eben jenen Betrag, um den man die Phosphorkonzentration abgesenkt hat.

Da die Phosphorkonzentration an der Oberfläche durch die Diffusion lateral langsam von der Normalkonzentration auf ein Minimum in der Mitte der ausmaskierten Zone absinkt, erreicht man auf diese Weise eine, den Anforderungen ideal entsprechende laterale Modulation der elektrisch aktiven Bordotierung in der Driftstrecke.

Die Abfolge eines beispielhaften Herstellungsprozesses für einen als PMOS-Transistor ausgeführten erfindungsgemäßen MOS-Transistor ist wie folgt:

### Prozeßabfolge

- Ausgangsmaterial p-Silizium Epi
- Wannen-Implantation Phosphor mit Wannenspalt
- Nachdiffusion und Feldoxidation LOCOS
- Schwellen- und Feldschwellen-Implantation NMOS (für die Driftstrecke/Drainextension)
- Schwellen-Implantation PMOS mit Ausmaskierung an der späteren drainseitigen Gatekante
- Poly-Deposition und Gatestrukturierung
- p+ Implantation PMOS Drain/Source (drainseitig mit Abstand von Gate und Aktivgebietskante)
- Zwischenoxid
- Kontaktlöcher
- Metallisierung

Nachfolgend wird die Erfindung anhand der Figuren näher erläutert. Im einzelnen zeigen:
- Fign. 1 bis 3: Querschnitte durch den oberflächennahen Bereich eines p-Substrats in verschiedenen Phasen des Herstellungsprozesses für einen spannungsfesten PMOS-Transistor mit geringem Einschaltwiderstand,
- Fign. 4 bis 6: Dotierstoffkonzentrationsverläufe an in den Fign. 2 und 3 näher bezeichneten Stellen des p-Substrats und
- Fig. 7: einen Querschnitt durch einen PMOS-Transistor ähnlich dem gemäß Fig. 3, jedoch mit zusätzlich eingebrachter Schwellenspannungsimplantation.

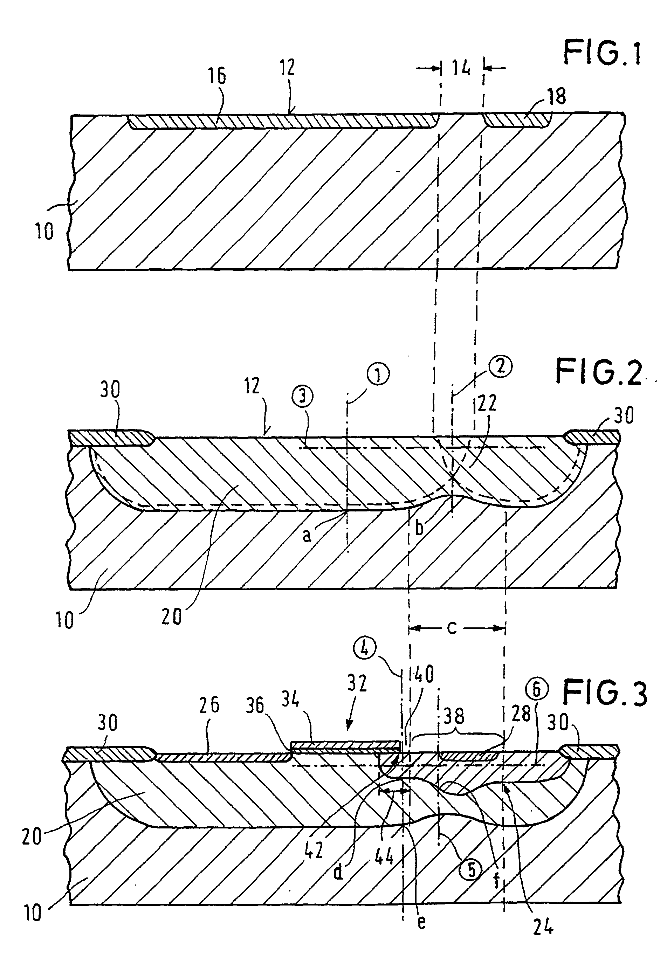

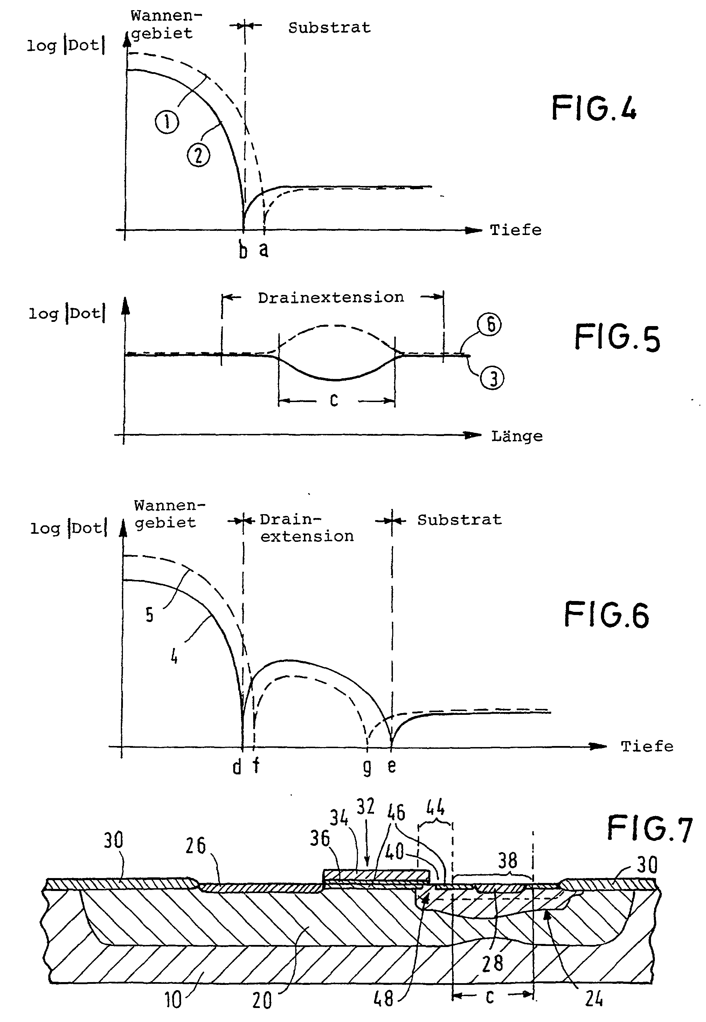

Fig. 1 zeigt ein p-Substrat 10, in dessen Oberfläche 12 zwei durch einen Abstandsbereich 14 voneinander beabstandete n-Ionenimplantationsgebiete 16,18 eingebracht sind. Diese beiden Gebiete 16,18 laufen bei der anschließenden thermisch induzierten Diffusion zum n-Wannengebiet 20 gemäß Fig. 2 zusammen. In dem dem Abstandsbereich 14 entsprechenden Verbindungsbereich 22 stellt sich dann zum einen eine verringerte Tiefe des n-Wannengebiets 20 und zum anderen eine verringerte Phosphor-Dotierstoffkonzentration ein. Dies ist anhand der beiden Kurven der Fig. 4 sowie anhand der Kurve 3 der Fig. 5 zu erkennen. In Fig. 4 ist mit der Kurve 1 das sich in Tiefenerstreckung der n-Wanne 20 außerhalb des Verbindungsbereichs 22 einstellende Dotierstoffkonzentrationsprofil als Betrag der Dotierstoffkonzentration dargestellt. Ausgehend von der Dotierstoffkonzentration an der Oberfläche 12 des p-Substrats 10 nimmt die Konzentration bis zum Grund des n-Wannengebiets 20 (pn-Übergang a der Fig. 2) ab, um dann mit zunehmender Tiefenerstreckung in das p-Substrat dessen Dotierstoffkonzentration anzunehmen.

Anders sieht die Situation im Falle der Kurve 2 der Fig. 4 aus. Von einem Dotierstoffkonzentrationswert an der Substrat-Oberfläche 12, der geringer ist als im Falle der Kurve 1, nimmt die Dotierstoffkonzentration bis zum pn-Übergang b, der oberhalb des pn-Übergangs a liegt, ab, um von dort aus mit zunehmender Tiefe in das p-Substrat 10 dessen Dotierstoffkonzentration anzunehmen.

In lateraler Richtung ergibt sich die Situation gemäß der Kurve 3 in Fig. 5. Im Verbindungsbereich 22 sowie beidseitig von diesem (bei c in Fign. 2 und 5 angedeutet), ergibt sich eine gegenüber dem übrigen Bereich des n-Wannengebiets 20 verringerte Dotierstoffkonzentration.

Fig. 3 zeigt die Situation nach Einbringung der Ionenimplantation für das Drainextension-Gebiet 24 sowie nach Ausbildung der Source- und Draingebiete 26,28 und des Feldoxids 30 sowie des Gates 32, das aus einer Gate-Elektrode 34 und dem dünnen Gate-Oxid 36 besteht. Aufgrund des Lateral-Dotierstoffkonzentrationsprofils der n-Wanne 20 im Bereich c weist das Drainextension-Gebiet 24, das durch über die gesamte Erstreckung konstante P-Bor-Ionenimplantation ausgebildet ist, eine erhöhte elektrisch aktive Dotierstoffkonzentration im Bereich c auf. Dieses Teilgebiet 38, innerhalb dessen das Draingebiet 28 ausgebildet ist, ist um den Abstandsbereich 40 von der drainseitigen Gate-Kante 42 beabstandet. Zum Gate 32 hin schließt sich an das Drainextension-Teilgebiet 38 ein Teilgebiet 44 an, das bis unter die drainseitige Gate-Kante 42 reicht. In diesem Teilgebiet 44 weist demzufolge das Drainextension-Gebiet 24 eine niedrigere Dotierstoffkonzentration auf als im Teilgebiet 38. Diese Situation ist ebenfalls in Fig. 5, Kurve 6, dargestellt. Diese Kurve 6 zeigt den Dotierstoffkonzentrationsverlauf in lateraler Erstreckung innerhalb des Drainextension-Gebiets 24. Die sich in der Tiefe einstellenden Dotierstoffkonzentrationsprofile innerhalb der beiden Teilgebiete 38 und 44 sind in Fig. 6 durch die Kurven 5 und 4 gezeigt. Die pn-Übergänge zwischen dem Drainextension-Gebiet 24 und dem n-Wannengebiet 20 einerseits sowie zwischen dem n-Wannengebiet 20 und dem p-Substrat 10 andererseits, sind bei d und e bzw. f und g in den Fign. 3 und 6 gezeigt.

Fig. 7 schließlich zeigt den PMOS-Transistor gemäß Fig. 3 mit zusätzlich eingebrachter Schwellenspannungsimplantation 46, wobei diese Implantation 46 im Bereich 48 um die drainseitige Gate-Kante 42 herum ausmaskiert ist.

## Patentansprüche

1. MOS-Transistor mit hoher Spannungfestigkeit und geringem Einschaltwiderstand mit
- einem Substrat (10), das eine Dotierung eines ersten Leitungstyps aufweist,
- einem in dem Substrat (10) ausgebildeten Wannengebiet (20), das eine Dotierung eines dem ersten Leitungstyp entgegengesetzten zweiten Leitungstyp aufweist,
- in dem Wannengebiet (20) ausgebildeten Source- und Drain-Gebieten (26,28) vom ersten Leitungstyp,
- einem eine Gate-Oxidschicht (36) aufweisenden Gate (32) zwischen dem Source-Gebiet (26) und dem Drain-Gebiet (28), wobei das Gate (32) einen drainseitigen Endbereich (42) aufweist, der von dem Drain-Gebiet (28) beabstandet ist (40), und
- einem Drainextension-Gebiet (24), das eine Dotierung vom ersten Leitungstyp aufweist und innerhalb dessen das Drain-Gebiet (28) ausgebildet ist, wobei das Drainextension-Gebiet (24) bis unterhalb des drainseitigen Endbereichs (42) des Gate (32) reicht,
**dadurch gekennzeichnet,**
- **dass** das Drainextension-Gebiet (24) mit implantierten Ionen versehen ist und einen ersten Teilbereich (44), der unterhalb des drainseitigen Endbereichs (42) des Gate (32) beginnt, sich in Richtung auf das Drain-Gebiet (28) erstreckt, und zwischen Gate (32) und Drain-Gebiet (28) endet, sowie einen sich in Richtung auf das Drain-Gebiet (28) an den ersten Teilbereich (44) anschließenden zweiten Teilbereich (38) aufweist, innerhalb dessen zumindest ein Teilbereich des Drain-Gebiets (28) angeordnet ist oder an den das Drain-Gebiet (28) angrenzt, wobei die Konzentration an elektrisch aktiver Dotierung vom ersten Leitungstyp im zweiten Teilbereich (38)-größer ist als im ersten Teilbereich (44) des Drainextension-Gebiets (24), und
- **dass** das Wannengebiet (20) zwei dotierte Teilbereiche aufweist, die durch thermisch induzierte Diffusion von in zwei Teilbereiche (16,18) implantierten Ionen gebildet sind,
- wobei die beiden Teilbereiche (16,18) um einen mit dem zweiten Teilbereich (38) ausgerichteten Abstandsbereich (14) voneinander beabstandet und innerhalb eines dem zweiten Teilgebiet (38) des Drainextension-Gebiets (24) entsprechenden Verbindungsbereichs (22) untereinander verbunden sind und
- wobei in diesem Verbindungsbereich (22)
- (i) die Konzentration an Dotierung vom zweiten Leitungstyp niedriger als im übrigen Bereich des Wannengebiets (20) und
- (ii) das Wannengebiet (20) weniger tief als in seinem übrigen Bereich
ist.

2. MOS-Transistor nach Anspruch 1, **dadurch gekennzeichnet, dass** sich unterhalb des Gate (32) mit Ausnahme des Übergangsbereichs zwischen der Gate-Oxidschicht (36) und dem Feldoxidsteg (38) der Einstellung der Schwellenspannung dienende Ionen befinden.

3. MOS-Transistor nach Anspruch 2, **dadurch gekennzeichnet, dass** die der Einstellung der Schwellenspannung dienenden Ionen sich auch in dem Drainextension-Gebiet (24) befinden.

4. MOS-Transistor nach einem der Ansprüche 1 bis 3, **dadurch gekennzeichnet, dass** die Dotierung vom ersten Leitungstyp eine p-Dotierung und die Dotierung vom zweiten Leitungstyp eine n-Dotierung ist.

## Claims

1. An MOS transistor with high voltage sustaining capability and low closing resistance comprising:
- a substrate (10) comprising a doping of a first conductive type,
- a well area (20) formed in the substrate (10) and provided with a doping of a second conductive type opposite to the first conductive type,
- source and drain areas (26, 28) of the first conductive type formed in the well area (20),
- a gate (32) comprising a gate oxide layer (36) and arranged between the source area (26) and the drain area (28), the gate (32) having drain-side end region (42) arranged at a distance (40) from the drain area (28), and
- a drain extension region (24) comprising a doping of the first conductive type and having the drain area (28) arranged therein, with the drain extension region (24) reaching below the drain-side end region (42) of the gate (32),
**characterized in**
- **that** the drain extension region (24) is provided with implanted ions and comprises a first partial area (44) starting below the drain-side end region (42) of the gate (32), extending in the direction of the drain area (28) and terminating between the gate (32) and the drain area (28), and a second partial area (38) joining the first partial area (44) in the direction of the drain area (28) and having at least a partial area of the drain area (28) arranged therein or having the drain area (28) bordering thereon, with the concentration of the electrically active doping of the first conductive type being larger in the second partial area (38) than in the first partial area (44) of the drain extension region (24), and
- **that** the well area (20) comprises two doped partial areas formed by thermally induced diffusion of ions implanted in two partial areas (16,18),
- wherein the two partial areas (16,18) are spaced from each other by a distance region (14) aligned with the second partial area (38) and are connected to each other within a connection region (22) corresponding to the second partial area (38) of the drain extension region (24),
- wherein, in this connection region (22),
- (i) the concentration of the doping of the second conductive type is lower than in the rest of the well area (20), and
- (ii) the well area (20) is less deep than in the rest of its region.

2. The MOS transistor according to claim 1, **characterized in that** ions serving for setting the threshold voltage are arranged below the gate (32) except for the transition region between the gate oxide layer (36) and the field oxide web (38).

3. The MOS transistor according to claim 2, **characterized in that** the ions serving for setting the threshold voltage are arranged also in the drain extension region (24).

4. The MOS transistor according to any one of claims 1 to 3, **characterized in that** the doping of the first conductive type is a p-doping and the doping of the second conductive type is an n-doping.

## Revendications

1. Transistor-MOS à rigidité diélectrique élevée et à faible résistance de fonctionnement comprenant
- un substrat (10) présentant un dopage d'un premier type de conductivité,
- un domaine de confinement (20) réalisé dans le substrat (10), qui présente un dopage d'un second type de conductivité opposé au premier type de conductivité,
- des domaines de source et de drain (26, 28) réalisés dans le domaine de confinement (20) du premier type de conductivité,
- une grille (32) présentant une couche d'oxyde de grille (36) entre le domaine de source (26) et le domaine de drain (28), la grille (32) présentant une zone terminale côté drain (42), qui est écartée (40) du domaine de drain (28), et
- un domaine d'extension de drain (24), qui présente un dopage du premier type de conductivité et à l'intérieur duquel est formé le domaine de drain (28), le domaine d'extension de drain (24) s'étendant jusqu'au-dessous de la zone terminale côté drain (42) de la grille (32),
**caractérisé**
- **en ce que** le domaine d'extension de drain (24) est implanté ioniquement et présente une première zone partielle (44), commençant au-dessous de la zone terminale côté drain (42) de la grille (32), s'étendant en direction du domaine de drain (28), et se terminant entre la grille (32) et le domaine de drain (28), ainsi qu'une seconde zone partielle (38) se raccordant à la première zone partielle (44) en direction du domaine de drain (28), à l'intérieur de laquelle est disposée au moins une zone partielle du domaine de drain (28) ou à laquelle est adjacent le domaine de drain (28), la concentration en dopage électrique actif du premier type de conductivité dans la seconde zone partielle (38) est plus élevée que dans la première zone partielle (44) du domaine d'extension de drain (24), et
- **en ce que** le domaine de confinement (20) présente deux zones partielles dopées, qui sont formées par diffusion induite thermiquement d'ions implantés dans deux zones partielles (16,18),
- les deux zones partielles (16,18) étant écartées l'une de l'autre avec une zone d'écartement (14) alignée sur la seconde zone partielle (38) et sont réunies l'une à l'autre à l'intérieur d'une zone de liaison (22) correspondant à la seconde zone partielle (38) du domaine d'extension de drain (24) et
- dans cette zone de liaison (22)
- (i) la concentration en dopage du second type de conductivité est plus faible que dans le reste du domaine de confinement (20) et
- (ii) le domaine de confinement (20) est moins profond que dans le reste de son domaine.

2. Transistor MOS selon la revendication 1, **caractérisé en ce qu'**au-dessous de la grille (32) à l'exception de la zone de transition entre la couche d'oxyde de grille (36) et de la bande d'oxyde de champ (38) se trouvant des ions servant au réglage de la tension de seuil.

3. Transistor MOS selon la revendication 2, **caractérisé en ce que** les ions servant au réglage de la tension de seuil se trouvent également dans le domaine d'extension de drain (24).

4. Transistor MOS selon une des revendications 1 à 3, **caractérisé en ce que** le dopage du premier type de conductivité est un dopage-p et le dopage du second type de conductivité est un dopage-n.
